# EUROPÄISCHE PATENTANMELDUNG

(11) **EP 3 264 113 A1**
(43) Veröffentlichungstag der Anmeldung: **03.01.2018**
(21) Anmeldenummer: 16176487.3
(22) Anmeldetag: 27.06.2016
(51) Int. Cl.: G01R 31/08

(54) **VERFAHREN UND ANORDNUNG ZUR LOKALISIERUNG VON STÖRUNGEN IN ELEKTRISCHEN VERTEILNETZEN**

(71) Anmelder: E.ON SE, 45131 Essen (DE)
(72) Erfinder: KNIZIA, Malte, 82349 Pentenried (DE); SIEPE, Marcus, 41564 Kaarst (DE)
(74) Vertreter: Glawe, Delfs, Moll

(57) **Zusammenfassung**

Die Erfindung betrifft ein Verfahren sowie eine Anordnung zur örtlichen Eingrenzung von Störungen in Verteilnetzen (1), insbesondere elektrischen Verteilnetzen.

Verfahren zur örtlichen Eingrenzung von Störungen (X) in einem elektrischen Verteilnetz (1) mit einer Empfangseinheit (9.1, 9.2, 9.3) umfassend ein Positionsbestimmungsmodul und mit einer Datenbank (12) umfassend Positionsinformationen über an dem Verteilnetz (1) angeschlossenen Geräten (4.1-4.11), die von der Empfangseinheit (9.1, 9.2, 9.3) identifizierbare und dem jeweiligen Gerät (4.1-4.11)zuordenbare Funksignale aussenden, umfassend die Schritte:
a. Ermitteln der aktiven, in der Nähe zur Empfangseinheit (9.1, 9.2, 9.3) befindlichen Geräten (4.1-4.11)anhand der von diesen Geräten (4.1-4.11)ausgesendeten identifizierbaren und dem jeweiligen Gerät (4.1-4.11) zuordenbaren Funksignale;
b. Bestimmen der Position der Empfangseinheit (9.1, 9.2, 9.3) durch das Positionsbestimmungsmodul;
c. Ermitteln von in der Nähe der Empfangseinheit (9.1, 9.2, 9.3) befindlichen Geräten (4.1-4.11)aus der Datenbank auf Basis der ermittelten Position der Empfangseinheit (9.1, 9.2, 9.3);
d. Ermitteln der deaktiven Geräte (4.1-4.11)in der Nähe der Empfangseinheit (9.1, 9.2, 9.3) durch Abgleich der ermittelten aktiven Geräte (4.1-4.11)mit den ermittelten in der Nähe der Empfangseinheit (9.1, 9.2, 9.3) befindlichen Geräte (4.1-4.11); und
e. Eingrenzen der Störung im Verteilnetz durch Auswertung der Positionsinformationen der ermittelten aktiven und deaktiven Geräte (4.1-4.11).

Die erfindungsgemäße Anordnung ist zur Durchführung dieses Verfahrens ausgebildet.

## Beschreibung

Die Erfindung betrifft ein Verfahren sowie eine Anordnung zur örtlichen Eingrenzung von Störungen in Verteilnetzen, insbesondere elektrischen Verteilnetzen.

Die von Großkraftwerken und dezentralen Energieerzeugern erzeugte elektrische Leistung wird über ein Leitungsnetz zu den Verbrauchern transportiert. Dabei wird die elektrische Leistung zur Überbrückung längerer Distanzen häufig zunächst über Hoch- oder Höchstspannungsnetze geleitet, bevor sie über Mittelspannungsnetze weiter verteilt wird. Bereits an den Mittelspannungsnetzen können einzelne industrielle Verbraucher unmittelbar angeschlossen sein. Der weit überwiegende Teil der Verbraucher, insbesondere Privathaushalte, bezieht elektrische Leistung jedoch über ein den Mittelspannungsnetz nachgelagertes Niederspannungsnetz.

In der Regel verfügen das Hoch- oder Höchstspannungsnetz sowie das Mittelspannungsnetz über Einrichtungen zur Netzüberwachung und werden in einer Leitstelle genau beobachtet, damit Störungen frühzeitig erkannt und ggf. beseitigt werden können. Dabei gestattet es die Netzüberwachung, die Position einer Störung im Netz genau zu lokalisieren, um entweder unmittelbar auf den Ort der Störung gerichtete Maßnahmen zur Beseitigung der Störung zu ergreifen oder den Ort der Störung zumindest kurzfristig vom übrigen Netz zu isolieren, damit sich die Störung nicht in andere Bereiche des Netzes fortpflanzt.

In Niederspannungsnetzen ist in der Regel keine derart detaillierte Überwachung vorgesehen. Vielmehr ist der Betreiber eines Niederspannungsverteilnetzes häufig auf die Meldung einer Störung, bspw. eines Stromausfalls, durch Dritte, bspw. Endkunden, angewiesen und kann dann erst mit der Suche nach der Störung beginnen. Dabei ist für den Betreiber im Besten Fall bereits aufgrund einer oder mehrere Meldungen ein Bereich seines Verteilnetzes eingrenzbar, in dem die Störung mit hoher Wahrscheinlichkeit liegt. Erhält der Betreiber eine Nachricht, dass der Strom bei einem Nutzer ausgefallen ist, lässt sich die Ursache der Störung nämlich z.B. zunächst in dem Leitungspfad von dem Punkt der Einspeisung der elektrischen Leistung in das Niederspannungsverteilnetz und der Adresse des Nutzers vermuten. Eine weitergehende Lokalisierung der Störung ist jedoch nicht ohne weiteres möglich. Der Betreiber muss daher den tatsächlichen Ort der Störung aufwendig suchen.

Aus dem Stand der Technik sind Verfahren und Anordnungen bekannt, mit denen Störungen in einem Niederspannungsverteilnetz genauer lokalisiert werden können. So schlägt bspw. die europäische Patentanmeldung EP 2 806 572 A1 eine Anordnung vor, bei dem über Kommunikation mit und zwischen an dem Niederspannungsverteilnetz angeschlossene intelligente Stromzähler ("Smartmeter"), die über die Leitungen des Netzes erfolgt, festgestellt werden kann, ob es zu messbaren Signalabschwächungen oder Kommunikationsabbrüchen kommt. Letztere können ein Hinweis auf den Ort der Störung liefern.

Nachteilig an diesem Stand der Technik ist, dass für die Lokalisierung von Störungen in Verteilnetzen zwingend erforderlich besondere Stromzähler, nämlich intelligente Stromzähler, vorgesehen sein müssen. Insbesondere für bereits vorhandene Netze ist der Austausch bereits vorhandener konventioneller Stromzähler mit intelligenten Stromzählern äußerst kostenintensiv und aufwendig.

Der Erfindung liegt die Aufgabe zu Grunde, ein Verfahren und eine Anordnung zur örtlichen Eingrenzung von Störungen in Verteilernetzen zu schaffen, bei denen die aus dem Stand der Technik bekannten Nachteile nicht mehr oder zumindest nur noch in verringertem Umfang auftreten.

Gelöst wird diese Aufgabe durch ein Verfahren gemäß dem Hauptanspruch sowie einer Anordnung gemäß dem unabhängigen Anspruch 11. Vorteilhafte Weiterbildungen sind Gegenstand der abhängigen Ansprüche.

Demnach betrifft die Erfindung Verfahren zur örtlichen Eingrenzung von Störungen in einem elektrischen Verteilnetz mit einer Empfangseinheit umfassend ein Positionsbestimmungsmodul und mit einer Datenbank umfassend Positionsinformationen über an dem Verteilnetz angeschlossenen Geräten, die von der Empfangseinheit identifizierbare und dem jeweiligen Gerät zuordenbare Funksignale aussenden, mit den Schritten:
a. Ermitteln der aktiven, in der Nähe zur Empfangseinheit befindlichen Geräten anhand der von diesen Geräten ausgesendeten identifizierbaren und dem jeweiligen Gerät zuordenbaren Funksignale;
b. Bestimmen der Position der Empfangseinheit durch das Positionsbestimmungsmodul;
c. Ermitteln von in der Nähe der Empfangseinheit befindlichen Geräte aus der Datenbank auf Basis der ermittelten Position der Empfangseinheit;
d. Ermitteln der deaktiven Geräte in der Nähe der Empfangseinheit durch Abgleich der ermittelten aktiven Geräten mit den ermittelten in der Nähe der Empfangseinheit befindlichen Geräten; und
e. Eingrenzen der Störung im Verteilnetz durch Auswertung der Positionsinformationen der ermittelten aktiven und deaktiven Geräte.

Weiterhin betrifft die Erfindung eine Anordnung zur örtlichen Eingrenzung von Störungen in einem elektrischen Verteilnetz umfassend eine Empfangseinheit mit einem Positionsbestimmungsmodul, eine Datenbank umfassend Positionsinformationen über an dem Verteilnetz angeschlossenen Geräten, die von der Empfangseinheit identifizierbare und dem jeweiligen Gerät zuordenbare Funksignale aussenden, und einen Rechner, wobei der Rechner dazu ausgebildet ist, anhand der von dem Positionsbestimmungsmodul der Empfangseinheit ermittelten Position aus der Datenbank die in der Nähe der Empfangseinheit befindlichen Geräte zu ermitteln und anhand der von der Empfangseinheit empfangenen Funksingale zu überprüfen, welche der so ermittelten Geräte aktiv und welche der so ermittelten Geräte deaktiv sind.

Zunächst werden einige in Zusammenhang mit der Erfindung verwendete Begriffe näher erläutert:
Von Geräten ausgesendete Funksignale sind im Sinne der Erfindung "identifizierbar und dem jeweiligen Gerät zuordenbar", wenn sich aus einem empfangenen Funksignal wenigstens ein unterscheidbares Identifikationsmerkmal ableiten lässt, welches sich zur Zuordnung des Funksignals zu einem einzelnen Gerät als eindeutige Quelle eignet. So weisen bspw. von Sendern für digitale Funknetze (bspw. ein "Wireless Local Area Network", WLAN) wiederholend ausgesendeten Funksignale zur Identifikation ("Beacons") neben einer Kennung des Netzes ("Service Set Identifier", SSID) regelmäßig auch eine den Sender bzw. das Gerät identifizierende Kennung ("Media-Access-Control"-Adressen, MAC-Adresse) auf, sodass bei Empfang des Funksignals eindeutig ein Gerät als Sender identifiziert werden kann. Vergleichbares gilt für die Signale anderer Funknetze, insbesondere digitaler Funknetze.

Ein Gerät gilt als "aktiv", wenn es Funksignale aussendet, die grundsätzlich von der Empfangseinheit empfangen werden können und identifizierbar und einem Gerät zuordenbar sind. Ein Gerät gilt dann als "deaktiv", wenn es zwar grundsätzlich geeignet ist, entsprechende Funksignale auszusenden, um als aktives Gerät im Sinne der Erfindung zu gelten, zu dem Zeitpunkt der Durchführung des erfindungsgemäßen Verfahrens aber keine Funksignale aussendet. Vorrichtungen, die keine Funksignale aussenden können, die grundsätzlich identifizierbar und zuordenbar sind, sind keine "Geräte" im Sinne der Erfindung.

Bei dem erfindungsgemäßen Verfahren zur Eingrenzung von Störungen in Verteilnetzen erfolgt ein Abgleich der von der Empfangseinheit empfangenen Funksignale tatsächlich aktiver Geräte mit den grundsätzlich zu erwartenden Funksignale von in der Nähe zur Position der Empfangseinheit befindlichen Geräten, die ausgehend von der Position der Empfangseinheit aus einer Datenbank ermittelt werden. Aus diesem Abgleich lässt sich ermitteln, welche Geräte in der Nähe der Empfangseinheit deaktiv sind. Die Information über aktive und deaktive Geräte kann herangezogen werden, um den Ort der Störung im Verteilnetz eingrenzen zu können. Dabei geht die Erfindung im Grundsatz davon aus, dass ans Verteilnetz angeschlossene aktive Geräte bei einer Störung im Verteilnetz, bspw. einem Stromausfall oder dem "Herausspringen" einer Sicherung, aufgrund des Wegfalls der Stromversorgung deaktiv werden.

Die bei der Erfindung verwendete Datenbank umfasst Positionsinformationen über an das Verteilnetz angeschlossene Geräte, die grundsätzlich dazu in der Lage sind, identifizier- und zuordenbare Funksignale auszusenden. Die Positionsinformationen können dabei Angaben zur geographischen Position, bspw. in Form von geographischen Koordinaten, und/oder Position in der Netztopologie umfassen. Mit "Position in der Netztopologie" ist dabei eine Angabe bezeichnet, aus der eindeutig hervorgeht, an welcher Leitung des Verteilnetzes ein Gerät angeschlossen ist oder über welchen Leitungsknoten des Verteilnetzes die Versorgung des Geräts mit elektrischer Leistung erfolgt.

Neben den Positionsinformationen können in der Datenbank noch weitere Informationen über die einzelnen Geräte hinterlegt sein. Beispielsweise sind Geräte bekannt, die nur zu bestimmten Zeiten bzw. in bestimmten Zeiträumen Funksignale aussenden. Ein typisches Beispiel hierfür sind WLAN-Zugangspunkte in öffentlichen Einrichtungen, die bspw. nur während der jeweiligen Öffnungszeiten aktiv sind. Um zu gewährleisten, dass ein entsprechendes, nur zeitweise aktives und im erfindungsgemäßen Verfahren als deaktiv ermitteltes Gerät fälschlicherweise als Hinweis auf eine mögliche Störung im Netz gesehen wird, obwohl es lediglich aufgrund eines vorgegebenen Zeitplans deaktiviert wurde, kann die Datenbank Informationen über die zeitabhängige Aktivierung und Deaktivierung von wenigstens einem Teil der an dem Verteilnetz angeschlossenen Geräte enthalten. So kann für nur zeitweise aktive Geräte überprüft werden, ob sie aufgrund des jeweiligen Zeitplans deaktiv sind oder ob eine Ermittlung des Gerätes als deaktiv ein Hinweis aus eine Störung im Netz darstellen könnte.

Es ist auch möglich, dass die Datenbank noch Informationen darüber enthält, ob an das Verteilnetz angeschlossene Geräte über eine unterbrechungsfreie Stromversorgung (USV) verfügen. Entsprechende Geräte mit USV senden grundsätzlich auch bei einer Störung im Netz und bspw. dem Wegfall der Versorgung mit elektrischer Leistung über das Verteilnetz zumindest noch über einen gewissen Zeitraum Funksignale aus, die von der Empfangseinheit als Hinweis auf ein aktives Gerät aufgefasst werden. Um zu vermeiden, dass ein entsprechendes Funksignal selbst bei Vorliegen einer Störung als Hinweis auf ein funktionierendes Versorgungsnetz aufgefasst wird, kann eine entsprechende Information in der Datenbank hilfreich sein, um Geräte mit unterbrechungsfreier Stromversorgung bei der örtlichen Eingrenzung von Störungen im Verteilnetz ggf. auszunehmen.

Bei dem erfindungsgemäßen Verfahren werden zunächst die aktiven, in der Nähe zur Empfangseinheit befindlichen Geräten ermittelt, wobei diese Ermittlung anhand der von diesen aktiven Geräten ausgesendeten Funksignale, die durch die Empfangseinheit identifizierbar und dem jeweiligen Gerät zuordenbar sind, erfolgt. Die Ermittlung kann bspw. in einer Liste der in der Nähe zur Empfangseinheit befindlichen und tatsächlich aktiven Geräte resultieren.

Anschließend wird die Position der Empfangseinheit über das ihr zugeordnete Positionsbestimmungsmodul ermittelt. Die Position der Empfangseinheit kann dabei durch aus dem Stand der Technik bekannte Verfahren ermittelt werden. So ist neben einer Ermittlung der Position der Empfangseinheit über Satellitennavigationssignale (bspw. GPS, Galileo oder GLONASS) auch eine Positionsbestimmung anhand von der Empfangseinheit identifizierbaren und einem Gerät zuordenbaren Funksignalen möglich. Sofern die Position der Geräte, deren Funksignale empfangen werden, bekannt ist, lässt sich daraus die ungefähre Position der Empfangseinheit ableiten. Die Position der fraglichen Geräte kann bspw. aus der zuvor beschriebenen Datenbank stammen. Insbesondere wenn es sich bei der Empfangseinheit um eine stationäre Einheit handelt, dessen Position grundsätzlich unverändert ist, kann eine Information über deren Position auch in einem Speicher abgelegt sein, von wo aus das Positionsbestimmungsmodul diese Information abruft. Der Speicher kann dabei unmittelbar der Empfangseinheit zugeordnet oder in Form einer Datenbank ausgelagert sein, aus der das Positionsmodul dann, bspw. mit Hilfe einer eindeutigen Kennung der Empfangseinheit die hinterlegte Position abrufen kann. Insbesondere bei mobilen Empfangseinheiten ist es auch möglich, regelmäßig die zuletzt ermittelte Position in dem Speicher abzulegen. Besteht dann die Anforderung zur Ermittlung der Position der Empfangseinheit kann auf die im Speicher abgelegte Position zurückgegriffen werden. Dies ist insbesondere von Vorteil, wenn eine tatsächliche Positionsbestimmung zum Zeitpunkt der Anforderung nicht möglich ist, bspw. weil auswertbare Funksignale fehlen.

Die Position der Empfangseinheit kann - ähnlich wie die Position der Geräte - in Form von geographischen Koordinaten und/oder als Position in der Netztopologie abgebildet sein. Die Art der Abbildung der Position der Empfangseinheit wird dabei insbesondere von der Art der Bestimmung der Position der Empfangseinheit sowie der Ausgestaltung der Empfangseinheit als mobile oder stationäre Einheit abhängen.

Insbesondere wenn das Positionsbestimmungsmodul zur Positionsbestimmung nicht auf die empfangenen Funksignale der aktiven Geräte zurückgreift, ist es auch möglich, dass die Bestimmung der Position des Empfangsmoduls parallel oder vor dem Ermitteln der aktiven, in der Nähe zur Empfangseinheit befindlichen Geräte erfolgt.

Ist die Position der Empfangseinheit bestimmt, werden die in der Nähe der Empfangseinheit befindlichen Geräte aus der Datenbank auf Basis der ermittelten Position der Empfangseinheit ermittelt. In anderen Worten wird über die Datenbank ermittelt, von welchen Geräten die Empfangseinheit aufgrund ihrer Position grundsätzlich Funksignale empfangen müsste, wobei - sofern verfügbar - Informationen über die zeitabhängige Aktivierung und Deaktivierung der Geräte selbstverständlich berücksichtigt werden können.

Durch Abgleich der so ermittelten in der Nähe befindlichen Geräte und der zuvor ermittelten aktiven Geräte lassen sich die in der Nähe zur Empfangseinheit befindlichen deaktiven Geräte ermitteln.

Unter der Annahme, dass zumindest ein erheblicher Teil der so ermittelten deaktiven Geräte aufgrund einer Störung im Netz deaktiv sind, lässt sich durch Auswertung der aus der Datenbank stammenden Positionsinformationen der ermittelten aktiven und deaktiven Geräte der Ort einer Störung im Verteilnetz in der Regel bereits eingrenzen:
- Wird von der Empfangseinheit kein Funksignal eines an das Verteilnetz angeschlossenen Gerätes oder nur Funksignale entsprechender Geräte mit unterbrechungsfreier Stromversorgung empfangen, lässt dies darauf schließen, dass alle in der Nähe der Empfangseinheit befindlichen Leitungen des Verteilnetzes von einer Störung betroffen sind. Je nach Topologie des Netzes kann dies darauf hinweisen, dass die Störung an einer zu den in der Nähe der Empfangseinheit befindlichen Leitungen vorgelagerten gemeinsamen Leitung besteht.
- Empfängt die Empfangseinheit Funksignale von sämtlichen, gemäß der Datenbank in der Nähe befindlichen Geräte, sind die in der Nähe der Empfangseinheit befindlichen Leitungen wahrscheinlich nicht von der Störung im Verteilnetz betroffen. Je nach Netztopologie kann daraus auch auf die Störungsfreiheit von einer den genannten Leitungen vorgelagerten gemeinsamen Leitung geschlossen werden.
- Werden von der Empfangseinheit nur von einem Teil der gemäß der Datenbank in der Nähe befindlichen Geräte Funksignale empfangen, lässt dies vermuten, dass zumindest ein großer Teil der als deaktiv ermittelten Geräte der Störung im Verteilnetz unterliegen. Da gleichzeitig ein anderer Teil der in der Nähe befindlichen Geräte offenbar aktiv ist, lässt sich eine Grenze zwischen einem störungsfreien Bereich des Netzes und einem von der Störung betroffenen Teil des Netzes ermitteln.

Dabei ist grundsätzlich unerheblich, ob die Positionsinformationen der Geräte in der Datenbank in Form von geographischen Positionsinformationen oder von Positionen in der Netztopologie vorliegen. Bei ausreichender Kenntnis der Netztopologie inkl. der Lage der Leitungen lassen sich die Positionsinformationen, sofern erforderlich, mit ausreichender Genauigkeit von der einen Form in die andere umrechnen.

Es ist bevorzugt, wenn die Datenbank Positionsinformationen von nicht an das Verteilnetz angeschlossenen Geräten, die von der Empfangseinheit identifizierbare und dem jeweiligen Gerät zuordenbare Funksignale aussenden, umfasst. Sofern die Positionsbestimmung der Empfangseinheit auf Basis von empfangenen Funksignalen erfolgt, ist so eine Positionsbestimmung auch dann noch möglich, wenn sämtliche in der Nähe befindliche und an dem Versorgungsnetz angeschlossene Geräte deaktiv sind, bspw. aufgrund einer Störung im Netz. Beispiele für nicht an das Verteilnetz angeschlossene Geräte sind batteriebetriebene Geräte, wie bspw. kabellose Fensterkontakte einer Heizungssteuerung oder einer Alarmanlage, Funkthermostate, etc.

Die an das Verteilnetz angeschlossenen Geräte können vorzugsweise netzbetreibereigene Geräte, wie bspw. Stromzähler und/oder Verteilerkästen, umfassen. Entsprechende Geräte bieten den Vorteil, dass sie unmittelbar eine eindeutige Position in der Netztopologie aufweisen, was die örtliche Eingrenzung von Störungen erleichtern kann.

Bei der Empfangseinheit kann es sich um einen (intelligenten) Stromzähler oder ein mobiles Endgerät, insbesondere ein sog. Smartphone oder Tablet, welches vorzugsweise über ein Mobilfunknetz kommunizieren kann, handeln. Ist die Empfangseinheit ein Stromzähler, verfügt dieser vorzugsweise über ein Kommunikationsmodul zum Senden und Empfangen von Daten. Dabei ist zu beachten, dass es - anders als im Stand der Technik - nicht erforderlich ist, dass alle Stromzähler eines Verteilnetz entsprechende ausgestattete Stromzähler sein müssen.

Ist die Empfangseinheit ein Mobiltelefon, können noch der Batterieladestatus und/oder der Lichteinfall auf eine Kamera des Mobiltelefons als Zusatzinformation über den Status des Verteilnetzes im Bereich der Empfangseinheit bei der Eingrenzung der Störung im Verteilnetz berücksichtigt werden. Stellt das Mobiltelefon fest, dass ein Ladevorgang sich plötzlich verändert, bspw. unterbrochen wird, kann vermutet werden, dass die Leitung, an der das Ladegerät des Mobiltelefons angeschlossen ist, von einer Störung des Versorgungsnetzes betroffen ist. Lässt sich in der Kamera in den Nachtstunden ein erheblicher Lichteinfall feststellen, ist zu vermuten, dass zumindest die Versorgung des elektrischen Lichts über das Versorgungsnetz nicht von einer Störung betroffen ist.

Grundsätzlich ist es möglich, dass die Datenbank unmittelbar bei der Empfangseinheit angeordnet ist. Es ist jedoch bevorzugt, wenn die Datenbank räumlich getrennt von der Empfangseinheit vorgehalten wird. Dies bietet den Vorteil, dass die Datenbank gleichzeitig von mehreren Empfangseinheiten genutzt werden kann und einfacher sichergestellt werden kann, dass die von einer Empfangseinheit verwendete Datenbank aktuell ist. Die Kommunikation zwischen Empfangseinheit und Datenbank kann zumindest bei Ausfall anderer Kommunikationswege, bspw. über das Verteilnetz selbst, dabei bevorzugt über ein Mobilfunknetz erfolgen. Die Komponenten eines Mobilfunknetzes verfügen in der Regel über eine Notstromversorgung, sodass das Mobilfunknetz auch bei Ausfall des Versorgungsnetzes regemäßig weiterhin verfügbar ist. Die Ermittlung von in der Nähe der Empfangseinheit befindlichen Geräten bzw. den deaktiven Geräten, kann durch die Empfangseinheit, seitens der Datenbank oder durch einen an die Datenbank und die Empfangseinheit angebundenen Rechner durchgeführt werden. Ein entsprechender Rechner kann bspw. in der Leitzentrale des Netzbetreibers vorgesehen sein.

Es ist bevorzugt, wenn die Datenbank selbstlernend ist und vorzugsweise Informationen betreffend den Anschluss an die Verteilnetze und/oder eine unterbrechungsfreie Stromversorgung einzelner Geräte bei Bedarf aktualisiert werden. Wird bspw. bei Ausfall einer Leitung des Versorgungsnetzes festgestellt, dass die Funksignale eines daran angeschlossenen Gerätes erst mit einer zeitlichen Verzögerung oder gar nicht ausbleiben, ist zu vermuten, dass dieses Gerät über eine unterbrechungsfreie Stromversorgung verfügt. Wird das Funksignal eines gänzlich unbekannten Gerätes identifiziert, lässt dies grundsätzlich darauf schließen, dass ein neues Gerät an das Verteilnetz angeschlossen wurde. Die Datenbank kann entsprechend erweitert werden, wobei die Positionsinformationen zunächst in Abhängigkeit von der Position der Empfangseinheit automatisiert geschätzt und im Laufe der Zeit präzisiert werden kann, bspw. indem bei jedem Empfang eines Funksignals dieses Gerätes überprüft wird, ob dessen Positionsinformationen grundsätzlich zutreffen können oder nicht. Im letzteren Fall werden die Positionsinformationen planvoll verändert. Selbstverständlich bleibt es auch bei einer selbstlernenden Datenbank möglich, einzelne Geräte manuell zu erfassen bzw. deren Datensatz zu aktualisieren.

Vorzugsweise sind die von der Empfangseinheit identifizierbaren und einem Gerät zuordenbare Funksignale WLAN-, Bluetooth-, Zigbee-, Z-Wave- und/oder EnOcean-Signale.

Zur Erläuterung der erfindungsgemäßen Anordnung wird auf die vorstehenden Ausführungen verwiesen.

Die Erfindung wird nun anhand eines vorteilhaften Ausführungsbeispiels unter Bezugnahme auf die beigefügten Zeichnungen beispielhaft beschrieben. Es zeigen:
Figur 1: ein erstes Ausführungsbeispiel einer erfindungsgemäßen Anordnung mit einem Versorgungsnetz im störungsfreien Zustand; und
Figur 2a-b: verschiedene Netzzustände der Anordnung aus Figur 1.

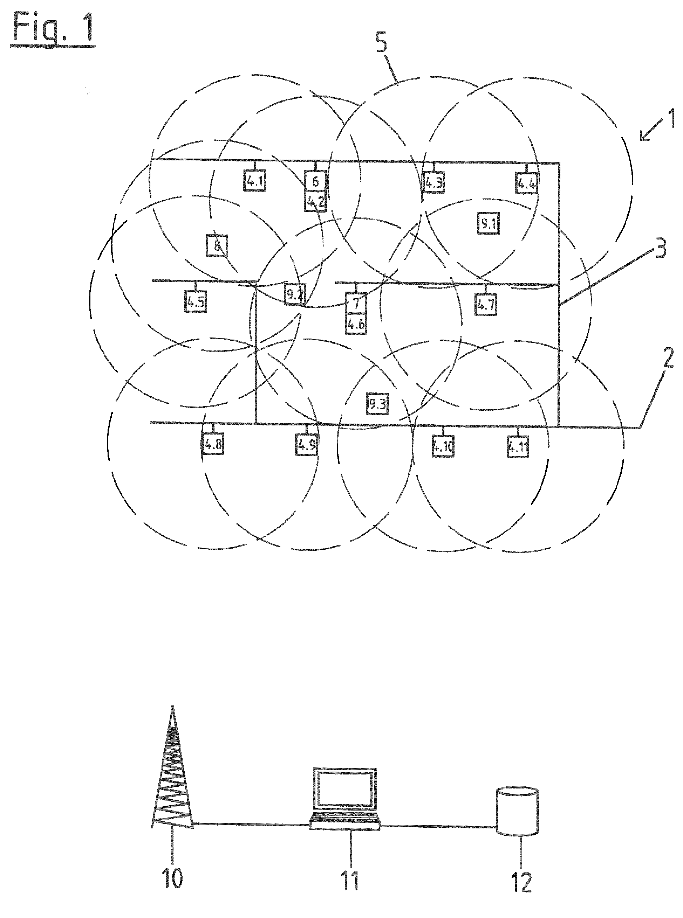

In Figur 1 ist schematisch ein elektrisches Verteilnetz 1 dargestellt, welches am Anbindungspunkt 2 mit einem (nicht dargestellten) vorgelagerten Netz verbunden ist und die von dort kommende elektrische Leitung über ein verzweigtes Leitungsnetz 3 verteilt.

An dem Verteilnetz 1 sind eine Vielzahl von Geräten 4.1 bis 4.11 angeschlossen, die im aktiven Zustand jeweils ein von einer der später noch erläuterten Empfangseinheiten 9.1 bis 9.3 identifizierbares und einem Gerät 4.1-4.11 eindeutig zuordenbares Funksignal abgeben. Die Reichweite des jeweiligen Funksignals ist durch die gestrichelten Kreise um die jeweiligen Geräte 4.1-4.11 angedeutet. Das Gerät 4.2 verfügt über eine unterbrechungsfreie Stromversorgung 6, sodass es selbst bei Ausfall des Verteilnetzes 1 noch weiter betrieben werden kann. Das Gerät 4.6 ist über eine Zeitschaltuhr 7 mit dem Verteilnetz 1 verbunden und nur in den Zeiten von 9:00 bis 17:00 Uhr aktiv.

Darüber hinaus ist noch ein weiteres Gerät 8 vorgesehen, welches zwar ebenfalls identifizierbare und zuordenbare Funksignale aussendet, jedoch vom Verteilnetz 1 vollkommen unabhängig mit einer Batterie betrieben wird.

Im Bereich des Verteilnetzes 1 sind in Figur 1 weiterhin drei Empfangseinheiten 9.1, 9.2 und 9.3 eingezeichnet. Bei diesen Empfangseinheiten 9.1, 9.2 und 9.3 handelt es sich um Mobiltelefone bzw. Smartphones, die zum Empfang der von den Geräten 4.1-4.11, 8 im aktiven Zustand ausgesendeten Funksignale ausgebildet ist und außerdem über ein Positionsbestimmungsmodul (nicht dargestellt) zur Bestimmung der Position der jeweiligen Empfangseinheiten 9.1, 9.2, 9.3 verfügen. Die Empfangseinheiten 9.1, 9.2 und 9.3 verfügen weiterhin über ein Kommunikationsmodul, sodass Daten betreffend die Position der Empfangseinheit 9.1, 9.2, 9.3 und der von der Empfangseinheit 9.1, 9.2, 9.3 empfangenen Funksignale über einen durch einen Mobilfunkmast 10 angedeutetes Mobilfunknetz an einen Rechner 11 übertragen werden können. Der Rechner 11 hat weiterhin Zugriff auf eine Datenbank 12.

In der Datenbank 12 sind Positionsinformationen zu sämtlichen Geräte 4.1-4.11, 8 verzeichnet, wobei die Informationen sowohl Angaben über die geographische Position in Form von geographischen Koordinaten als auch Angaben zur Position in der Netztopologie - also an welcher Leitung 3 im Versorgungsnetz 1 das jeweilige Gerät 4.1-4.11, 8 angeschlossen ist - umfasst. Weiterhin ist in der Datenbank 12 vermerkt, dass das Gerät 4.2 über eine unterbrechungsfreie Stromversorgung 6 verfügt, das Gerät 4.6 nur zu bestimmten Tageszeiten eingeschaltet ist und das Gerät 8 batteriebetrieben ist.

Regelmäßig, bei Feststellung eines plötzlichen Wegfalls eines oder mehrere Funksignale, oder auf ausdrücklichen Befehl eines Nutzers hin übermittelt eine Empfangseinheit 9.1, 9.2, 9.3 die Informationen über die empfangenen Funksignale, anhand derer die Geräte 4.1-4.11, 8 identifizierbar und die einzelnen Funksignale einem einzelnen Gerät 4.1-4.11, 8 eindeutig zuordenbar sind, über das Mobilfunknetz 10 an den Rechner 11. Daneben übermitteln die Empfangseinheiten 9.1, 9.2, 9.3 noch die von ihrem jeweiligen Positionsbestimmungsmodul ermittelte Position der Empfangseinheit 9.1, 9.2, 9.3. Im vorliegenden Ausführungsbeispiel erfolgt die Positionsbestimmung anhand von GPS-Signalen, wobei die Positionsbestimmungsgenauigkeit auf bekannte Weise durch die Auswertung von WLAN-Signalen - bei denen es sich bspw. um von den Geräten 4.1-4.11, 8 ausgesendeten Funksignalen handeln kann - erhöht werden kann. Die Position der Empfangseinheit 9.1, 9.2, 9.3 wird in geographischen Koordinaten bestimmt.

Der Rechner 11 kann auf Basis der von der von einer Empfangseinheit 9.1, 9.2, 9.3 erhaltenen Position anhand der Datenbank 12 ermitteln, welche Geräte 4.1-4.11, 8 sich grundsätzlich in der Nähe der jeweiligen Empfangseinheit 9.1, 9.2, 9.3 befinden. In anderen Worte lässt sich ermitteln, von welchen Geräten 4.1-4.11, 8 eine Empfangseinheit 9.1, 9.2, 9.3 angesichts der jeweiligen Reichweite 5 grundsätzlich Funksignale empfangen sollte, sofern die Geräte 4.1-4.11, 8 aktiv sind. Im dargestellten Ausführungsbeispiel sind die für die Empfangseinheit 9.1 bspw. die Geräte 4.3, 4.4 und 4.7, für die Empfangseinheit 9.2 die Geräte 4.1, 4.2, 4.5, 4.6 und 8 und für die Empfangseinheit 9.3 die Geräte 4.6, 4.9 und 4.10.

Im in Figur 1 dargestellten störungsfreien Zustand des Versorgungsnetzes 1 sind sämtliche Geräte 4.1-4.11, 8 aktiv und senden somit Funksignale aus, die - sofern sie sich in der jeweiligen Reichweite 5 befinden - von dem Empfangseinheiten 9.1, 9.2, 9.3 empfangen werden können. Die von den Empfangseinheiten 9.1, 9.2, 9.3 übermittelten Informationen zu den empfangenen Funksignalen, die seitens des Rechners 11 mit Hilfe der Datenbank 12 eindeutig den die Funksignale jeweils aussendenden Geräten 4.1-4.11, 8 zugeordnet werden können, stimmen in diesem Fall vollständig mit den zuvor jeweils als in der Nähe zu den Empfangseinheiten 9.1, 9.2, 9.3 ermittelten Geräten. Ein entsprechender von dem Rechner 11 durchgeführter Abgleich legt nahe, dass keine Störung im Versorgungsnetz 1 vorliegt, da alle überprüfbaren ans Netz angeschlossenen Geräte 4.1-4.7, 4.9, 4.10 offensichtlich aktiv sind. Könnte von einem der genannten Geräte kein Funksignal empfangen werden, kann grundsätzlich davon ausgegangen werden, dass das betroffene Gerät deaktiv ist, was wiederum ein Hinweis auf eine Störung im Netz darstellen kann.

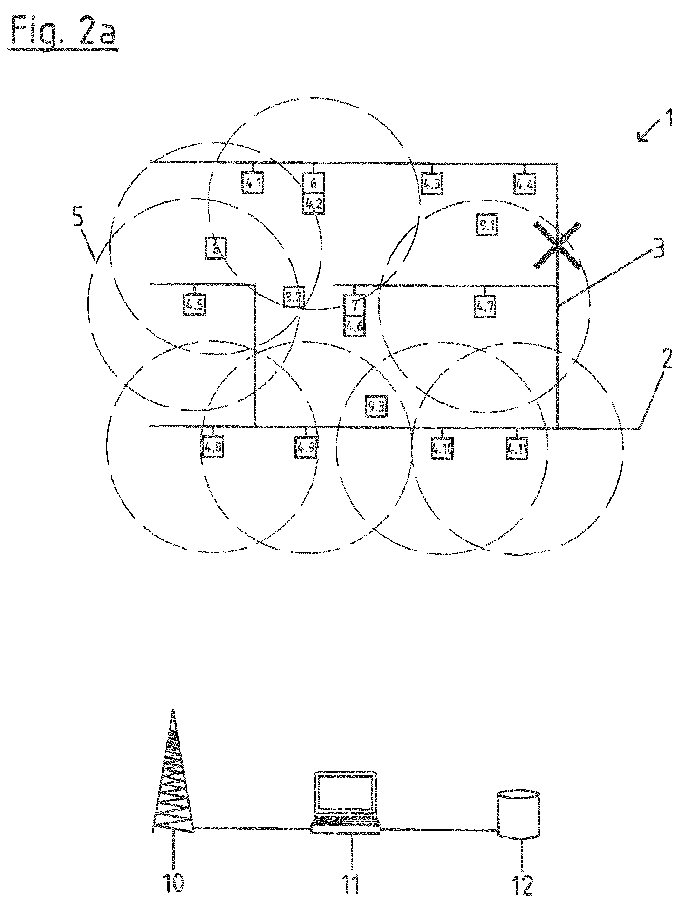

In Figur 2a ist ein erster Störungsfall des Versorgungsnetzes 1 gemäß Figur 1 dargestellt. Die eigentliche Störung ist als X markiert und unterbricht die Stromversorgung der ausgehend vom Anbindungspunkt 2 hinter der Störung liegenden Geräte vollständig. Von der Störung sind somit die Geräte 4.1, 4.2, 4.3 und 4.4 betroffen.

Erfolgt nun der zuvor beschriebene Abgleich der von den Empfangseinheiten 9.1, 9.2, 9.3 tatsächlich empfangenen Funksignalen mit denjenigen, die laut der Datenbank 12 empfangen werden müssten, können für jede Empfangseinheit 9.1, 9.2, 9.3 aktive und deaktive Geräte 4.1-4.11, 8 ermittelt werden.

Für die Empfangseinheit 9.1 kann so festgestellt werden, dass die Geräte 4.3, 4.4, deren Funksignale grundsätzlich empfangen werden müssten, offensichtlich deaktiv sind, während das Gerät 4.7 noch Funksignale sendet, das Gerät 4.7 also aktiv ist. Bereits mit diesen Informationen lässt sich aus der Netztopologie - ggf. automatisiert durch den Rechner 11 - ableiten, dass die Störung vermutlich zwischen der Leitungsabzweigung 3.1 und dem Gerät 4.4 liegt.

Die Ergebnisse der anderen Empfangseinheiten 9.2 und 9.3 können diese Vermutung bestätigen. Da die Empfangseinheit 9.3 weiterhin die Funksignale der Geräte 4.9 und 4.10 empfängt, kann vermutet werden, dass die Leitung zwischen dem Anbindungspunkt 2 und dem Geräte 4.9 störungsfrei ist. Dass von dem Gerät 4.6 keine Funksignale empfangen werden können, stellt hingegen keinen Hinweise auf eine Störung in dessen Zuleitung dar, da dieses Gerät 4.6 im in Figur 2a dargestellten Zustand durch die Zeitschaltuhr 7 ausgeschaltet ist und somit planvoll deaktiviert wurde. Da entsprechende Information über die zeitweise Deaktivierung des Geräts 4.6 in der Datenbank 12 hinterlegt ist, kann der Rechner 11 das Ausbleiben der Funksignale des Gerätes 4.6 als ordnungsgemäßen und nicht auf eine Netzstörung hinweisenden Zustand identifizieren.

Auch die Empfangseinheit 9.2 kann keine Funksignale des Gerätes 4.6 mehr empfangen, was aber ebenfalls anhand der Informationen aus der Datenbank 12 nicht als Störfall des Versorgungsnetzes 1 aufgefasst wird. Da die Empfangseinheit 9.2 weiterhin keine Signale vom Gerät 4.1, sondern nur von den Geräten 4.2, 4.5 und 8 empfängt, deutet ebenfalls auf eine Störung in der Leitung 3, die ausgehend von der Leitungsabzweigung 3.1 zum Gerät 4.1 führt hin. Da aus der Datenbank 12 bekannt ist, dass das Gerät 4.2 über eine unterbrechungsfreie Stromversorgung verfügt, wird vermieden, dass die Funksignale dieses Gerätes 4.2 fälschlicherweise als Hinweis auf eine funktionierende Energieversorgung des Gerätes 4.2 durch das Versorgungsnetz 1 angesehen wird.

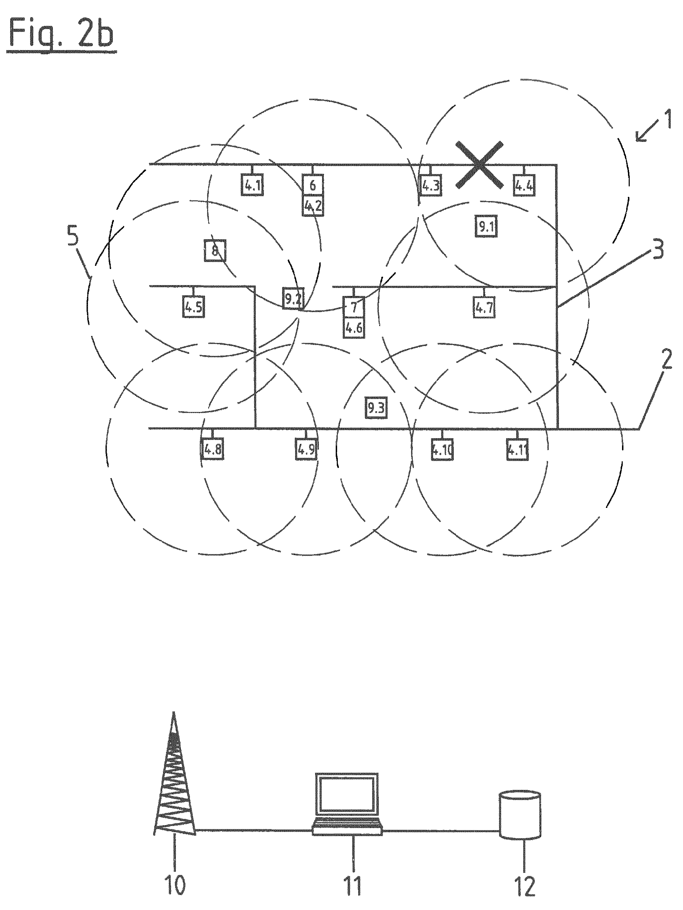

In Figur 2b ist ein alternativer Störungsfall des Versorgungsnetzes 1 gemäß Figur 1 dargestellt. In diesem Fall tritt die als X markierte Störung in der Leitung zwischen den Geräten 4.3 und 4.4 auf.

Für die Empfangseinheiten 9.2 und 9.3 ist die Situation gegenüber dem Störungsfall aus Figur 2a unverändert, weshalb auf die dortigen Ausführungen verwiesen wird.

Die Empfangseinheit 9.1 empfängt in Abweichung zu diesem vorbeschrieben Störungsfall bei dem Störungsfall gemäß Figur 2b aber zusätzlich noch die Funksignale des Geräts 4.4. Durch die Auswertung des Rechners 11, wie in Zusammenhang mit Figuren 1 und 2b beschrieben, kann so unmittelbar festgestellt werden, dass sich die Störung vermutlich in der Leitung zwischen Gerät 4.3 und 4.4 liegt.

Bei den von den Geräten 4.1-4.11, 8 ausgesendeten Funksignale handelt es sich um WLAN-Signale, insbesondere um WLAN-Beacons, die empfangen und ausgewertet werden können, ohne dass bspw. eine Empfangseinheit 9.1, 9.2, 9.3 mit dem entsprechenden WLAN verbunden werden müsste.

## Patentansprüche

1. Verfahren zur örtlichen Eingrenzung von Störungen (X) in einem elektrischen Verteilnetz (1) mit einer Empfangseinheit (9.1, 9.2, 9.3) umfassend ein Positionsbestimmungsmodul und mit einer Datenbank (12) umfassend Positionsinformationen über an dem Verteilnetz (1) angeschlossenen Geräten (4.1-4.11), die von der Empfangseinheit (9.1, 9.2, 9.3) identifizierbare und dem jeweiligen Gerät (4.1-4.11) zuordenbare Funksignale aussenden, mit den Schritten:
a. Ermitteln der aktiven, in der Nähe zur Empfangseinheit (9.1, 9.2, 9.3) befindlichen Geräte (4.1-4.11)anhand der von diesen Geräten (4.1-4.11)ausgesendeten identifizierbaren und dem jeweiligen Gerät (4.1-4.11) zuordenbaren Funksignale;
b. Bestimmen der Position der Empfangseinheit (9.1, 9.2, 9.3) durch das Positionsbestimmungsmodul;
c. Ermitteln von in der Nähe der Empfangseinheit (9.1, 9.2, 9.3) befindlichen Geräte (4.1-4.11)aus der Datenbank auf Basis der ermittelten Position der Empfangseinheit (9.1, 9.2, 9.3);
d. Ermitteln der deaktiven Geräte (4.1-4.11)in der Nähe der Empfangseinheit (9.1, 9.2, 9.3) durch Abgleich der ermittelten aktiven Geräte (4.1-4.11)mit den ermittelten in der Nähe der Empfangseinheit (9.1, 9.2, 9.3) befindlichen Geräte (4.1-4.11) ; und
e. Eingrenzen der Störung im Verteilnetz durch Auswertung der Positionsinformationen der ermittelten aktiven und deaktiven Geräte (4.1-4.11).

2. Verfahren nach Anspruch 1,
**dadurch gekennzeichnet, dass**
die Positionsinformationen Angaben zur geographischen Position und/oder zur Position in der Netztopologie umfassen.

3. Verfahren nach Anspruch 1 oder 2,
**dadurch gekennzeichnet, dass**
die Datenbank (12) umfassend Positionsinformationen Informationen über die zeitabhängige Aktivierung und Deaktivierung von wenigstens einem Teil der an dem Verteilnetz (1) angeschlossenen Geräte (4.6) und/oder Informationen darüber, ob an das Verteilnetz (1) angeschlossene Geräte (4.2) über eine unterbrechungsfreie Stromversorgung (6) verfügen, umfassen.

4. Verfahren nach einem der vorhergehenden Ansprüche,
**dadurch gekennzeichnet, dass**
die Datenbank (12) Positionsinformationen von nicht an das Verteilnetz (1) angeschlossenen Geräten (8), die von der Empfangseinheit (9.1, 9.2, 9.3) identifizierbare und dem jeweiligen Gerät (8) zuordenbare Funksignale aussenden, umfasst.

5. Verfahren nach einem der vorhergehenden Ansprüche,
**dadurch gekennzeichnet, dass**
die an das Verteilnetz (1) angeschlossenen Geräte (4.1-4.11) netzbetreibereigene Geräte, vorzugsweise Stromzähler und/oder Verteilerkästen, umfassen.

6. Verfahren nach einem der vorhergehenden Ansprüche,
**dadurch gekennzeichnet, dass**
die Empfangseinheit (9.1, 9.2, 9.3) ein Stromzähler oder ein mobiles Endgerät, vorzugsweise ein Smartphone oder ein Tablet, ist.

7. Verfahren nach Anspruch 6,
**dadurch gekennzeichnet, dass**
der Veränderung des Ladevorgangs und/oder der Lichteinfall auf eine Kamera des Mobiltelefons als Zusatzinformation über den Status des Verteilnetzes (1) im Bereich der Empfangseinheit (9.1, 9.2, 9.3) bei der Eingrenzung der Störung im Verteilnetz (1) berücksichtigt werden.

8. Verfahren nach einem der vorhergehenden Ansprüche,
**dadurch gekennzeichnet, dass**
die Datenbank (12) selbstlernend ist und vorzugsweise Informationen betreffend den Anschluss an die Verteilnetze und/oder eine unterbrechungsfreie Stromversorgung (6) einzelner Geräte (4.1-4.11) bei Bedarf aktualisiert werden.

9. Verfahren nach einem der vorhergehenden Ansprüche,
**dadurch gekennzeichnet, dass**
das Positionsbestimmungsmodul zur Bestimmung der Position der Empfangseinheit (9.1, 9.2, 9.3) über Satellitennavigationssignale, über eine Auswertung der von der Empfangseinheit (9.1, 9.2, 9.3) identifizierbaren und einem Gerät (4.1-4.11, 8) zuordenbaren Funksignalen und/oder durch Abruf einer in einem Speicher hinterlegten Position ausgebildet ist.

10. Verfahren nach einem der vorhergehenden Ansprüche,
**dadurch gekennzeichnet, dass**
die von der Empfangseinheit (9.1, 9.2, 9.3) identifizierbaren und einem Gerät (4.1-4.11, 8) zuordenbare Funksignale WLAN-, Bluetooth-, Zigbee-, Z-Wave- und/oder EnOcean-Signale sind.

11. Anordnung zur örtlichen Eingrenzung von Störungen (X) in einem elektrischen Verteilnetz (1) umfassend eine Empfangseinheit (9.1, 9.2, 9.3) mit einem Positionsbestimmungsmodul, eine Datenbank (12) umfassend Positionsinformationen über an dem Verteilnetz (1) angeschlossenen Geräten (4.1-4.11), die von der Empfangseinheit (9.1, 9.2, 9.3) identifizierbare und dem jeweiligen Gerät (4.1-4.11) zuordenbare Funksignale aussenden, und einen Rechner (11),
**dadurch gekennzeichnet, dass**
der Rechner (11) dazu ausgebildet ist, anhand der von dem Positionsbestimmungsmodul der Empfangseinheit (9.1, 9.2, 9.3) ermittelten Position aus der Datenbank (12) die in der Nähe der Empfangseinheit (9.1, 9.2, 9.3) befindlichen Geräte zu ermitteln und anhand der von der Empfangseinheit (9.1, 9.2, 9.3) empfangenen Funksingale zu überprüfen, welche der so ermittelten Geräte aktiv und welche der so ermittelten Geräte deaktiv sind.

12. Anordnung nach Anspruch 11,
**dadurch gekennzeichnet, dass**
die Anordnung zur Durchführung eines Verfahrens gemäß einem der Ansprüche 1-10 ausgebildet ist.
